(19) Europäisches Patentamt
European Patent Office
Office européen des brevets

(11) Numéro de publication: **0 102 888 B1**

(12) # FASCICULE DE BREVET EUROPEEN

(45) Date de publication du fascicule du brevet: **27.08.86**

(51) Int. Cl.[4]: **H 03 D 9/06**

(21) Numéro de dépôt: **83401632.1**

(22) Date de dépôt: **09.08.83**

(54) **Mélangeur d'ondes électromagnétiques hyperfréquences à récupération de la fréquence somme.**

(30) Priorité: **20.08.82 FR 8214435**

(43) Date de publication de la demande:
**14.03.84 Bulletin 84/11**

(45) Mention de la délivrance du brevet:
**27.08.86 Bulletin 86/35**

(84) Etats contractants désignés:
***DE GB IT***

(56) Documents cités:
**DE - B - 1 102 221**
**US - A - 3 652 941**
**US - A - 4 211 987**

**TECHNICAL DIGEST OF IEEE INTERNATIONAL ELECTRON DEVICES MEETING, 6-8 *décembre* 1976, pages 87-89, New York, USA, E.J. DENLINGER et al.: "High performance mixer diode"**
**DIGEST OF TECHNICAL PAPERS OF 1971 IEEE-GMTT INTERNATIONAL MICROWAVE SYMPOSIUM, 16-19 mai 1971, pages 16-17, New York, USA, J.B. CAHALAN et al.: "An integrated, X-band, image and sum frequency enhanced mixed with 1GHz If"**
**IEEE TRANSACTIONS ON CONSUMER ELECTRONICS, vol. CE-27, no. 3, août 1981, pages 410-415, New York, USA, T. UWAMO et al.: "An MDS down converter of**

(73) Titulaire: **THOMSON-CSF, 173, Boulevard Haussmann, F-75379 Paris Cedex 08 (FR)**

(72) Inventeur: **Fraise, Pierre, THOMSON-CSF SCPI 173, bld Haussmann, F-75379 Paris Cedex 08 (FR)**

(74) Mandataire: **Weinmiller, Jürgen et al, Zeppelinstrasse 63, D-8000 München 80 (DE)**

(56) Entgegenhaltungen: *(Fortsetzung)*
**thick-film MIC for 2 GHZ pay TV"**
**PROCEEDINGS 1971 EUROPEAN MICROWAVE CONFERENCE, 23-28 août 1971, pages A11/5:1-A11/5:4, Royal Swedish Academy of Engineering Sciences, Stockholm, SE., T.H. OXLEY et al.: "Image recovery mixers"**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne les mélangeurs d'ondes électromagnétiques hyperfréquences constitués par des éléments actifs électroniques non-linéaires, du type à diodes ou à transistors, utilisables plus particulièrement dans les récepteurs de télécommunication.

On entend par mélangeur, un dispositif électronique, par exemple selon le document US-A-3 652 941, qui assure le mélange de deux signaux périodiques de fréquences différentes, pour délivrer sur sa sortie un signal unique dont le spectre de fréquence contient au moins une fréquence égale à la somme ou à la différence des fréquences des deux signaux qui lui sont appliqués, la fréquence différence étant appelée communément «fréquence intermédiaire».

Un problème fondamental qui est à résoudre lorsque l'on cherche à construire un mélangeur, est celui de réduire au maximum les pertes de conversion. Les pertes de conversion correspondent à la différence, mesurée généralement en décibels, entre la puissance disponible à l'entrée du mélangeur, et la puissance disponible à sa sortie.

En théorie les pertes de conversion pourraient être nulles si la sortie était parfaitement adaptée aux fréquences des raies du spectre du signal de sortie du mélangeur, et si toutes les puissances des raies non essentielles du spectre étaient récupérées.

Or dans la pratique il est impossible de contrôler toutes les impédances de terminaison d'un mélangeur pour chaque fréquence. Par conséquent les pertes de conversion ne sont jamais nulles et plus elles sont importantes, plus elles sont nuisibles à la sensibilité du récepteur couplé en sortie.

Pour diminuer les pertes de conversion, une méthode connue consiste à placer sur l'accès signal du mélangeur des filtres réjecteurs de bande accordés sur certaines fréquences du spectre du signal de sortie, pour réfléchir, sur les éléments électroniques non-linéaires les raies correspondantes du signal de sortie mélangé et obtenir par un nouveau mélange avec d'autres fréquences privilégiées du spectre, des composantes de signal en phase et de même fréquence que le signal de fréquence intermédiaire $F_O$ obtenu par le mélange direct.

On connaît, par exemple, des mélangeurs à réjecteurs de bandes réalisés en microcircuit, formés par des guides d'ondes ou des lignes à fentes déposés par métallisation sur un substrat, pour récupérer et réfléchir au niveau des éléments électroniques non-linéaires du mélangeur, la fréquence image $F_I$, c'est-à-dire la fréquence symétrique de la fréquence $F_S$ du signal appliquée sur une entrée du mélangeur par rapport à la fréquence du signal mélangeur $F_L$ appliquée sur l'autre entrée. La fréquence image $F_I = 2F_L - F_S$ produite par les éléments électroniques non-linéaires, est réfléchie sur ceux-ci par le filtre réjecteur de bande et un nouveau mélange de la fréquence image $F_I$ avec la fréquence du signal mélangeur donne une fréquence $F_L - F_I = F_L - (2F_L - F_S) = F_S - F_L = F_O$ qui est la même que la fréquence intermédiaire obtenue par le mélange directe des fréquences, incidente $F_S$ et mélangeuse $F_L$. Dans la mesure où le signal correspondant obtenu est en phase avec le signal de fréquence intermédiaire obtenu par le mélange direct, ces dispositifs permettent d'obtenir une augmentation de l'amplitude de sortie du signal de fréquence intermédiaire $F_O$ et par conséquent la diminution des pertes de conversion recherchée.

De la même façon, il serait possible d'envisager, pour diminuer les pertes de conversion, de réfléchir la fréquence «somme», résultant de l'addition directe par le mélangeur des fréquences d'entrée $(F_L + F_S)$, en direction des éléments électroniques non-linéaires à l'aide également d'un filtre réjecteur de bande accordé sur la fréquence «somme». Le mélange, de la fréquence $F_S$ du signal incident avec la fréquence double $2F_L$ du signal mélangeur, donne également, dans ce cas, une fréquence intermédiaire $F_O$ suivant l'opération:

$$F_O = (F_L + F_S) - 2F_L = F_S - F_L$$

Dans la mesure où le signal de fréquence $F_O$, obtenu par l'opération précédente, est en phase avec le signal de fréquence intermédiaire, une diminution supplémentaire des pertes de conversion doit être obtenue.

Malheureusement, il s'avère que la maîtrise de la fréquence «somme» $F_S + F_L$ ne peut être obtenue à l'aide des techniques de réalisation des guides d'ondes en microcircuit, à cause de divers effets parasites dus à l'apparition d'ondes de surface, à la dispersion des guides d'ondes à microruban ou à ligne à fente utilisés et aux effets de résonance provoqués par le boîtier et son couvercle renfermant les circuits électroniques du mélangeur. Ces difficultés sont particulièrement dues au fait que la fréquence «somme» se situe à peu près à une fréquence double de la fréquence du signal appliquée à l'entrée du mélangeur, car habituellement, le signal de fréquence intermédiaire a une fréquence $F_O$ qui est bien inférieure à la fréquence $F_S$ du signal appliqué sur l'entrée du mélangeur.

Le but de l'invention est de remédier aux inconvénients précités en réalisant un mélangeur qui permette une récupération de la fréquence «somme» au niveau des éléments actifs non-linéaires, pour diminuer d'autant les pertes de conversion en tirant parti des phénomènes de résonance qui habituellement sont considérés comme des phénomènes parasitaires et par conséquent indésirables.

A cet effet, l'invention a pour objet un mélangeur d'ondes électromagnétiques hyperfréquences, comportant un circuit microélectronique composé d'un ou plusieurs éléments actifs électroniques à caractéristique non-linéaire portés sur un substrat, alimentés par des lignes guide d'onde placées sur le substrat, le circuit microélectronique étant fixé à l'intérieur d'un boîtier fermé et étant relié à des bornes de connexion placées sur le boîtier, pour mélanger une onde incidente S de

fréquence $F_S$ appliquée sur une première borne du boîtier avec une onde mélangeuse OL de fréquence $F_L$ appliquée sur une deuxième borne du boîtier et restituer une onde mélangée de fréquence $F_O$ sur une troisième borne, caractérisé en ce que la cavité formée par l'espace intérieur du boîtier est accordée sur une fréquence «somme» représentant la somme de la fréquence de l'onde mélangeuse $F_L$ et de la fréquence de l'onde incidente $F_S$ pour récupérer et réfléchir en direction desdits éléments actifs ladite fréquence «somme».

D'autres caractéristiques et avantages de l'invention apparaîtront au cours de la description faite au regard des dessins annexés, donnés uniquement à titre d'exemple et dans lesquels:

– La figure 1 représente un schéma de principe équivalent du mélangeur hyperfréquence selon l'invention.

– La figure 2 représente un mode de réalisation du circuit représenté à la figure 1, en technique de fabrication des guides d'ondes et des lignes à fente par métallisation de rubans sur un substrat.

La figure 3 représente une vue de-dessus du circuit mélangeur de la figure 2 dans un boîtier refermé par un couvercle.

La figure 4 est une vue suivant la coupe a, a' du mélangeur représenté à la figure 3.

Le mélangeur représenté suivant le schéma de principe de la figure 1 est constitué par un transformateur 1 comprenant, un enroulement primaire 2, deux demi-enroulements secondaires 3 et 4 reliés ensemble, par une de leurs extrémités, pour former un point milieu 5. Deux diodes 6 et 7 sont montées en série entre chacune des extrémités opposées au point milieu 5 des enroulements 3 et 4, la cathode d'une diode 6 étant reliée à l'anode de l'autre diode 7 pour former un point de liaison commun 10. Le signal incident S à mélanger est appliqué par une source de signal extérieure, non représentée, entre la ligne de masse M du circuit et le point commun 10 par l'intermédiaire d'un condensateur 11. Le signal melangeur OL est appliqué aux bornes de l'enroulement primaire 2 du transformateur 1, par un oscillateur local extérieur, non représenté. Le signal mélangé OR est obtenu à la sortie d'un filtre passe-bas 12 dont l'entrée est reliée au point commun 10 de liaison entre les deux diodes 6 et 7. Ce filtre passe-bas est constitué par une inductance 13 dont une extrémité est connectée au point de liaison commun 10 et dont l'autre extrémité constituant la sortie du circuit mélangeur est reliée à la ligne de masse M par l'intermédiaire d'un condensateur 14. Un filtre réjecteur de bande 15, accordé sur la fréquence image, $F_I = 2F_L - F_S$, produite par les diodes, représentant la différence entre le double de la fréquence de l'oscillateur local et la fréquence du signal appliquée, est placé entre la ligne de masse M et le point commun 10 des diodes 6 et 7, de façon, à réfléchir la fréquence image en direction des deux diodes 6 et 7 pour qu'un nouveau mélange puisse être effectué avec la fréquence $F_L$ de l'oscillateur local, pour obtenir une fréquence intermédiaire $F_O$ égale à la fréquence obtenue par le mélange direct des fréquences $F_S$ du signal appliqué et $F_L$ de l'oscillateur local et diminuer ainsi les pertes de conversion. De la même façon un filtre réjecteur de bande 18 est placé entre le point de liaison commun aux deux diodes 10 et la masse pour réfléchir la fréquence «somme» en direction des deux diodes 6 et 7 et obtenir, par mélange de la fréquence «somme» = $F_S + F_L$ avec la fréquence double $2F_L$ de la fréquence de l'oscillateur local, générées toutes les deux par les diodes, une composante de fréquence $F_O$ égale à la fréquence obtenue par le mélange direct de la fréquence $F_S$ du signal appliquée à l'entrée du mélangeur avec la fréquence $F_L$ de l'oscillateur local. Le filtre réjecteur de bande 18 permet, dans ces conditions, comme le filtre réjecteur de bande 15, de diminuer les pertes de conversion.

Un mode de réalisation, selon l'invention, du mélangeur représenté suivant le schéma de principe de la figure 1 est représenté à l'aide des figures 2 à 4. Il comprend un substrat 21, composé par deux faces rectangulaires planes, 21a et 21b, parallèles entre elles et espacée de quelques dizièmes de millimètres, constitué par un matériau à permittivité élevée du type titanate de magnésium, alumine ou verre téflon. Une fine couche d'un matériau conducteur 22 est déposée par métallisation sur la première face 21a. Un conducteur 23, déposé par métallisation d'un ruban sur la face 21b, est relié par une extrémité à une borne 24 placée contre un côté de la face 21b et a son autre extrémité libre placée directement en regard d'une ligne à fente 25, pratiquée par gravure ou autre moyens analogues dans la couche métallisée 22. La ligne à fente 25 et le conducteur 23 ont des directions à peu près perpendiculaires. La ligne à fente 25 comprend deux bords internes parallèles, 25a et 25b, et a une première extrémité élargie, terminée par un évasement 26 et une deuxième extrémité élargie terminée par un évasement 27. La ligne à fente 25 et le conducteur 23 sont également disposés de façon que la première extrémité de la ligne à fente 25 soit en regard de la deuxième extrémité du conducteur 23. Des trous 28 et 29, traversant le substrat 21 dans toute son épaisseur, sont pratiqués à la hauteur de la deuxième extrémité de la ligne à fente 25 à proximité respectivement des bords 25a et 25b. Des diodes 30 et 31 sont montées tête-bêche à l'intérieur respectivement des trous 28 et 29. La cathode de la diode 31 est connectée au bord 25a de la ligne à fente et l'anode de la diode 30 est connectée au bord 25b de la ligne à fente. Les autres extrémités des diodes 30 et 31 sont connectées sur un côté d'une plaque 32 de forme à peu près rectangulaire. Le côté opposé au côté de connexion des diodes 30 et 31 de la plaque 32 est relié à une première extrémité d'un conducteur 33, déposé par métallisation d'un ruban sur la face 21b dont l'autre extrémité est laissée libre et est en regard d'une borne de connexion 34 située sur la face 21b sur le côté opposé au côté sur lequel est placée la borne de connexion 24. La borne de connexion 34 est reliée à première extrémité d'un conducteur 35 déposée par métallisation d'un ruban sur la face 21b

du substrat, l'autre extrémité du conducteur 35 est laissée libre. Les conducteurs 33 et 35 sont disposés de façon à avoir des directions à peu près parallèles. Une plaque 36, de forme à peu près rectangulaire, est déposée par métallisation sur la face 21b du substrat, un premier côté de la plaque 36 étant relié à une première extrémité d'un conducteur 37 déposé par métallisation d'un ruban sur la face 21b du substrat, l'autre extrémité du conducteur 37 étant reliée sur la plaque 32 à la première extrémité du conducteur 33. Le côté opposé au premier côté de la plaque 36 est relié à une première extrémité d'un conducteur 38 déposé par métallisation d'un ruban sur la face 21b et l'autre extrémité du conducteur 38 est connectée à une borne de connexion 39 placée sur la face 21b du substrat. Une ligne à fente 40 est pratiquée dans la couche métallique 22 selon une direction à peut près perpendiculaire aux directions des conducteurs 33 et 35. Une première extrémité de la ligne à fente 40 est placée directement en regard du point de connexion commun des conducteurs 33, 37 avec la plaque 32. L'autre extrémité 42 de la ligne à fente 40 est repliée ce qui permet une réduction des dimensions du substrat 21.

Le fonctionnement du mélangeur représenté à la figure 2 est le suivant. Le champ électrique de l'onde du signal OL créé par l'oscillateur local, extérieur au mélangeur, est appliqué entre la borne 24 et la couche métallique 22 et se propage en direction des diodes 30 et 31 par l'intermédiaire de la ligne à fente 25 qui est couplée sur sa première extrémité au conducteur 23 directement relié à la borne de connexion 24. La ligne à fente 25 et le conducteur 23 jouent le rôle du transformateur 1 représenté à la figure 1 et les bords 25a et 25b de la ligne à fente 25 vibrent en opposition de phase au point de connexion des diodes 30 et 31. La plaque 32 joue le rôle du point de connexion 10 de la figure 1 et applique le champ électrique créé par l'onde du signal d'entrée S du mélangeur, appliquée sur la borne de connexion 34, aux extrémités des diodes 30 et 31 connectées à la plaque 32 au travers du condensateur formé par les conducteurs parallèles 33 et 35. La plaque 36 et les conducteurs 37 et 38 jouent le rôle du filtre passe-bas 12 de la figure 1. L'onde du signal mélangé OR de fréquence intermédiaire $F_0$ est obtenue sur la borne 39. La ligne à fente 40 a une longueur qui correspond à la demi-longueur d'onde de la fréquence image produite par les diodes et constitue ainsi le filtre réjecteur de bande 15 de la figure 1. Le filtre réjecteur de bande 18 de la figure 1 n'est pas construit directement sur le substrat 21 et fait partie du dispositif représenté aux figures 3 et 4 qui représentent le circuit du mélangeur de la figure 2 monté dans un boîtier 43 fermé par un couvercle 44. Le boîtier 44 a la forme d'un parallélépipède rectangle et comprend trois prises coaxiales 45, 46 et 47. La prise 45 assure la liaison entre la borne 24 du substrat 21 et un câble coaxial extérieur, non représenté, pour le transport de l'onde du signal OL fourni par l'oscillateur local. La prise 46 assure la liaison entre la borne 34 du substrat et un câble coaxial extérieur, non représenté, qui transporte l'onde du signal S incident. La prise 47 relie la borne 39 à un câble coaxial extérieur, non représenté, qui transporte l'onde du signal OR fourni par le mélangeur. Le boîtier 43 comporte également figure 4, un fond 48, délimité par les parois 49 à 52, sur lesquelles est pratiqué un rebord en saillie 53 pour maintenir le substrat 21 à l'intérieur du boîtier 43 selon une direction parallèle au fond 48. Le couvercle 44 est muni d'une vis 54 le traversant dans son épaisseur et faisant saillie à l'intérieur du boîtier. La hauteur de la partie en saillie de la vis 54 est ajustée de façon à faire entrer en résonance la cavité du boîtier formée par le couvercle 44, le fond 48 et les parois 49 à 52 selon une fréquence qui correspond à la fréquence «somme» de résonance du filtre à réjecteur de bande 18 de la figure 1. L'alimentation de la cavité en énergie est réalisée par les éléments du microcircuit eux-mêmes qui rayonnent la fréquence «somme». Pour ne pas perturber le fonctionnement du mélangeur, la vis 54 est placée en regard d'une partie du substrat 21 suffisamment éloignée du circuit actif du mélangeur.

L'invention n'est pas limitée au mélangeur précédemment décrit, il va de soi qu'elle s'applique également à d'autres variantes de réalisations dans lesquels, notamment d'autres formes de cavités, par exemple, cylindriques peuvent être adoptées. Egalement l'accord de la cavité sur la fréquence «somme» peut être réalisé par des moyens équivalents à celui précédemment décrit et qui ne sont pas obligatoirement fixés par le couvercle du boîtier.

**Revendications**

1. Mélangeur d'ondes électromagnétiques hyperfréquences, comportant un circuit microélectronique composé d'un ou plusieurs éléments actifs électroniques à caractéristique non-linéaire (30, 31) portés sur un substrat (21) alimentés par des lignes guide d'onde placées sur le substrat, le circuit microélectronique étant fixé à l'intérieur d'un boîtier (43) fermé et étant relié à des bornes (45, 46, 47) de connexion placées sur le boîtier pour mélanger une onde incidente (S) de fréquence $F_S$ appliquée sur une première borne (46) du boîtier avec une onde mélangeuse (OL) de fréquence $F_L$ appliquée sur une deuxième borne (45) du boîtier et restituer une onde mélangée (OR) de fréquence $F_0$ sur une troisième borne (47), caractérisé en ce que la cavité formée par l'espace (48, 49, 50, 51, 44) intérieur du boîtier est accordée sur une fréquence «somme» représentant la somme de la fréquence de l'onde mélangeuse $F_L$ et de la fréquence de l'onde incidente $F_S$ pour récupérer et réfléchir en direction desdits éléments actifs ladite fréquence «somme».

2. Mélangeur selon la revendication 1, caractérisé en ce que le boîtier est fermé par un couvercle (44) dont la face, délimitant l'espace intérieur du boîtier, comprend une partie en saillie (54) pour accorder la cavité interne du boîtier sur la fréquence «somme».

3. Mélangeur selon la revendication 2, caractérisé en ce que la hauteur de la saillie (54) au-dessus de la face du couvercle est ajustable.

4. Mélangeur selon la revendication 3, caractérisé en ce que la partie en saillie (54) est constituée par une vis traversant l'épaisseur du couvercle.

5. Mélangeur selon l'une quelconque des revendications 1 à 4, caractérisé en ce que la partie en saillie de la face du couvercle est placée dans une partie de la cavité à une distance suffisamment éloignée des guides d'ondes placés sur le substrat.

6. Mélangeur selon l'une quelconque des revendications 1 à 5, caractérisé en ce que le substrat a une forme à peu près plate.

7. Mélangeur selon la revendication 6, caractérisé en ce que le couvercle est parallèle à la direction plane du substrat.

8. Mélangeur selon l'une quelconque des revendications précédentes, caractérisé en ce que la cavité est parallélépipédique.

9. Mélangeur selon l'une quelconque des revendications 1 à 7 caractérisé en ce que la cavité est cylindrique.

10. Mélangeur selon l'une quelconque des revendications 1 à 9, caractérisé en ce qu'il comprend également des moyens (40) portés par le substrat pour récupérer la fréquence image ($F_1$) égale à deux fois la fréquence ($F_L$) de l'onde mélangeuse diminuée de la fréquence ($F_S$) de l'onde incidente pour réfléchir la fréquence image sur les éléments actifs électroniques à caractéristiques non-linéaire.

**Patentansprüche**

1. Mischstufe für elektromagnetische Mikrowellen mit einem Mikroelektronikkreis, der aus einem oder mehreren aktiven elektronischen Elementen mit nicht linearer Charakteristik (30, 31) zusammengesetzt ist, die sich auf einem Substrat (21) befinden und von auf dem Substrat angeordneten Wellenleitern gespeist werden, wobei der Mikroelektronikkreis im Inneren eines geschlossenen Gehäuses (43) befestigt ist und an Anschlussklemmen (45, 46, 47) angeschlossen ist, die sich auf dem Gehäuse befinden, um eine einfallende Welle (S) einer Frequenz $F_S$, die an einer ersten Klemme (46) des Gehäuses anliegt, mit einer Mischwelle (OL) einer Frequenz $F_L$ zu mischen, die an eine zweite Klemme (45) des Gehäuses angelegt ist, und um eine gemischte Welle (OR) einer Frequenz $F_0$ an einer dritten Klemme (47) abzugeben, dadurch gekennzeichnet, dass der durch den Innenraum (48, 49, 50, 51, 44) des Gehäuses gebildete Hohlraum auf eine Summenfrequenz abgestimmt ist, die die Summe der Frequenzen der Mischwelle $F_L$ und der einfallenden Welle $F_S$ darstellt, um diese Summenfrequenz zu entnehmen und in Richtung auf die aktiven Elemente zu reflektieren.

2. Mischstufe nach Anspruch 1, dadurch gekennzeichnet, dass das Gehäuse von einem Deckel (44) verschlossen wird, dessen den Innenraum des Gehäuses verschliessende Seite einen vorspringenden Bereich (54) aufweist, um den inneren Hohlraum des Gehäuses auf die Summenfrequenz abzustimmen.

3. Mischstufe nach Anspruch 2, dadurch gekennzeichnet, dass die Höhe des Vorsprungs (54) bezüglich der Deckelfläche einstellbar ist.

4. Mischstufe nach Anspruch 3, dadurch gekennzeichnet, dass der vorspringende Bereich (54) von einer Schraube gebildet wird, die die Dicke des Deckels durchquert.

5. Mischstufe nach einem beliebigen der Ansprüche 1 bis 4, dadurch gekennzeichnet, dass der vorspringende Bereich bezüglich der Deckelseite in einem Teil des Hohlraums liegt, der hinreichend weit von den auf dem Substrat liegenden Wellenleitern entfernt ist.

6. Mischstufe nach einem beliebigen der Ansprüche 1 bis 5, dadurch gekennzeichnet, dass das Substrat eine nahezu ebene Form besitzt.

7. Mischstufe nach Anspruch 6, dadurch gekennzeichnet, dass der Deckel parallel zur ebenen Richtung des Substrats liegt.

8. Mischstufe nach einem beliebigen der vorhergehenden Ansprüche, dadurch gekennzeichnet, dass der Hohlraum parallelepipedisch ist.

9. Mischstufe nach einem beliebigen der Ansprüche 1 bis 7, dadurch gekennzeichnet, dass der Hohlraum zylindrisch geformt ist.

10. Mischstufe nach einem beliebigen der Ansprüche 1 bis 9, dadurch gekennzeichnet, dass sie ausserdem Mittel (40) auf dem Substrat aufweist, um die Bildfrequenz ($F_I$) gleich der doppelten Frequenz ($F_L$) der Mischwelle verringert um die Frequenz ($F_S$) der einfallenden Welle zu erfassen und um die Bildfrequenz auf die aktiven elektronischen Elemente mit nicht-linearen Kennwerten zu reflektieren.

**Claims**

1. A mixer for electromagnetic microwaves comprising a microelectronic circuit composed of at least one active electronic element (30, 31) having a nonlinear characteristic and carried on a substrate (21), said elements being supplied by waveguide lines placed on the substrate, the microelectronic circuit being fixed inside a closed casing (43) and connected to connection terminals (45, 46, 47) placed on the casing in order to mix an incident wave (S) having a frequency $F_S$ and applied to a first terminal (46) of the casing with a mixer wave (OL) having a frequency $F_L$ and applied to a second terminal (45) of the casing, and in order to restitute on a third terminal (47) a mixed wave (OR) having a frequency $F_O$, characterized in that the cavity formed by the internal space (48, 49, 50, 51, 44) of the casing is tuned to a «sum» frequency representing the sum of the frequency of the mixer wave $F_L$ and of the frequency of the incident wave $F_S$ in order to recover and reflect said «sum» frequency onto said active elements.

2. A mixer according to claim 1, characterized in that the casing is closed by a cover (44), the face of said cover which delimits the internal space of said casing being provided with a projecting portion (54) for tuning the internal cavity of the casing to the «sum» frequency.

3. A mixer according to claim 2, characterized in that the height of the projecting portion above the face of the cover is adjustable.

4. A mixer according to claim 3, characterized in that the projecting portion (54) consists of a screw which extends right through the cover.

5. A mixer according to any one of claims 1 to 4, characterized in that the portion which projects from the face of the cover is placed within an area of the cavity located at a sufficient distance from the waveguides which are placed on the substrate.

6. A mixer according to any one of claims 1 to 5, characterized in that the substrate has an approximately flat shape.

7. A mixer according to claim 6, characterized in that the cover is parallel to the flat direction of the substrate.

8. A mixer according to any one of the preceding claims, characterized in that the cavity is parallelepipedal.

9. A mixer according to any one of claims 1 to 7, characterized in that the cavity is cylindrical.

10. A mixer according to any one of claims 1 to 9, characterized in that said mixer also comprises means (40) carried by the substrate for recovering the image frequency ($F_I$) which is equal to twice the frequency ($F_L$) of the mixer wave reduced by the frequency ($F_S$) of the incident wave, in order to reflect the image frequency on the active electronic elements having nonlinear characteristics.

1/1

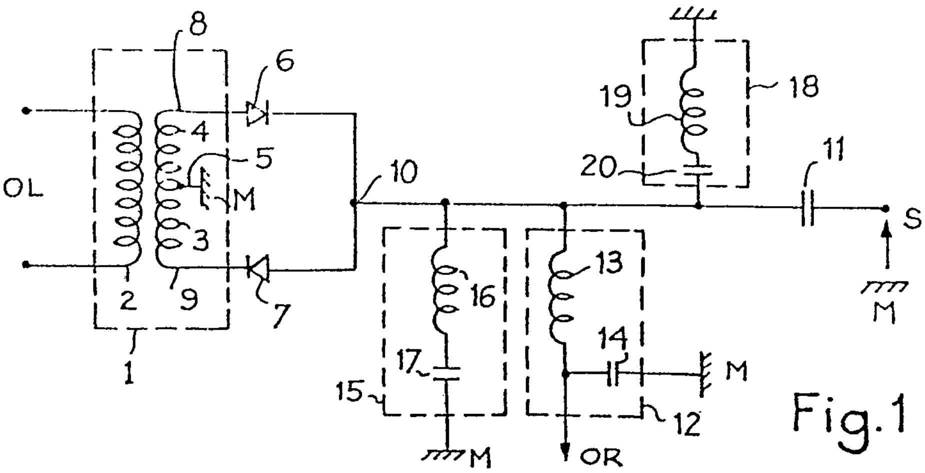


Fig.1

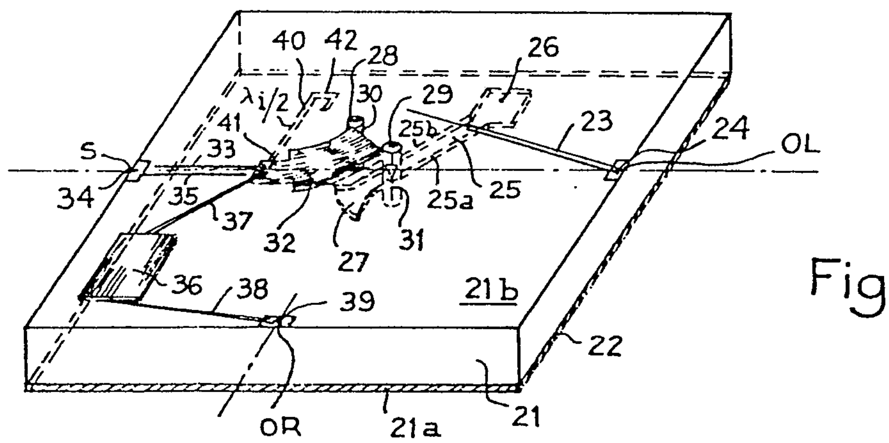


Fig.2

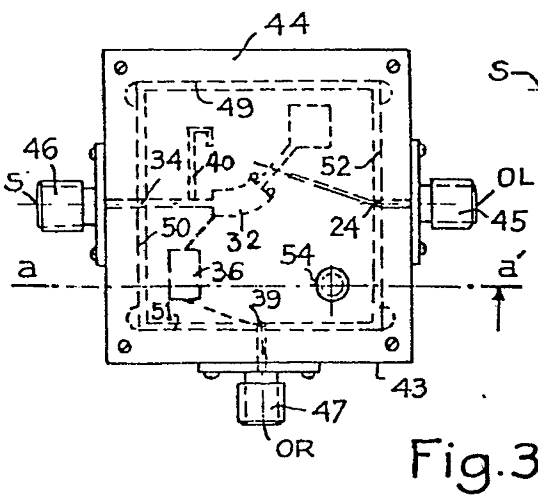


Fig.3

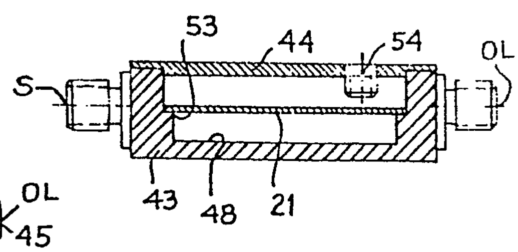


Fig.4 Coupe a,a'